# EUROPEAN PATENT SPECIFICATION

(11) **EP 4 617 957 B1**
(45) Date of publication and mention of the grant of the patent: **26.08.2026**
(21) Application number: 24220879.1
(22) Date of filing: 18.12.2024
(51) Int. Cl.: G06N 10/40, G06N 10/20, G06N 10/70

(54) **PERFORMING QUANTUM PROCESSING**
DURCHFÜHRUNG VON QUANTENVERARBEITUNG
RÉALISATION DE TRAITEMENT QUANTIQUE

(30) Priority: 11.03.2024 US 202418601805
(43) Date of publication of application: 17.09.2025
(73) Proprietor: Infineon Technologies Austria AG, 9500 Villach (AT)
(72) Inventor: HARTMANN, Michael, 80803 München (DE); BRANDL, Matthias, 85614 Kirchseeon (DE)
(74) Representative: Infineon Patent Department

(56) References cited:
- WO-A2-2022/146577
- CN-A- 117 389 178
- US-A1- 2023 297 872
- CHAUHAN NITESH ET AL: "Trapped ion qubit and clock operations with a visible wavelength photonic coil resonator stabilized integrated Brillouin laser", ARXIV.ORG, 27 February 2024 (2024-02-27), pages 1 - 13, XP093280721, Retrieved from the Internet <URL:https://arxiv.org/pdf/2402.16742> [retrieved on 20250523]
- DURANDAU JONATHAN ET AL: "Automated Generation of Shuttling Sequences for a Linear Segmented Ion Trap Quantum Computer", vol. 7, 31 October 2023 (2023-10-31), pages 1175, XP093280740, ISSN: 2521-327X, Retrieved from the Internet <URL:https://arxiv.org/pdf/2208.04881> [retrieved on 20250516], DOI: 10.22331/q-2023-11-08-1175
- SCHOENBERGER DANIEL ET AL: "Shuttling for Scalable Trapped-Ion Quantum Computers", vol. 44, no. 6, 21 February 2024 (2024-02-21), USA, pages 2144 - 2155, XP093280741, ISSN: 0278-0070, Retrieved from the Internet <URL:https://arxiv.org/pdf/2402.14065v1> [retrieved on 20250516], DOI: 10.1109/TCAD.2024.3513262

## Description

### TECHNICAL FIELD

The present disclosure relates to an approach for performing quantum processing of one or more particles.

### BACKGROUND

There is a growing interest in systems configured for performing quantum processing of one or more particles. Typically, such systems comprise one or more quantum processing tasks components, each of which are configured to perform a respective quantum processing task for or on the one or more particles.

More specifically, quantum processing task components are elements within the system that are designed or configured to carry out specific processing operations ("quantum processing tasks") on the quantum particles. These components may include, but are not limited to, devices for particle trapping, application of light, cooling, shuttling or movement of a particle, performing quantum gate operations, measuring, and/or performing error corrections. For example, a laser system might be used to cool and/or trap a particle, while precisely controlled electromagnetic fields could be employed to manipulate the quantum states of these trapped particles.

These individual quantum processing tasks may be able to function as building blocks for the creation of more complex quantum algorithms and protocols, e.g., through appropriate combination and/or sequencing of the tasks.

Chauhan Nitesh ET AL: "Trapped ion qubit and clock operations with a visible wavelength photonic coil resonator stabilized integrated Brillouin laser" discloses chip-scale optical clock and qubit operations on a ion using a photonic integrated direct-drive visible wavelength Brillouin laser stabilized to an integrated 3-meter coil resonator reference cavity and the optical clock transition of a 88Sr+ ion trapped on a surface electrode chip. The clocking protocol is relatively fast, as it is only limited by the detection time (2 ms) and cooling time (2 ms) for the ion between cycles, and not by the interrogation time.

It is therefore the object of the present invention to provide an improved system for performing quantum processing of one or more particles with a control system and a corresponding particle trapping device.

### SUMMARY

The invention is set forth in the independent claim 1 and further embodiments are defined in the dependent claims 2-15.

### BRIEF DESCRIPTION OF THE DRAWINGS

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.
Fig. 1 exemplarily illustrates a system in which embodiments may be employed.
Fig. 2 conceptually illustrates a proposed control approach.
Fig. 3 conceptually illustrated a proposed system.
Fig. 4 exemplarily illustrates an existing control approach.
Fig. 5 exemplarily illustrates a proposed control approach.

### DETAILED DESCRIPTION

The examples described herein provide a mechanism for controlling the operation of one or more quantum processing task components. A control system is configured to allow or permit each quantum processing task component to initiate or change a quantum processing task at a non-zero integer multiple of a predefined clocking period, which is no less than a period of time taken by one of the quantum processing task components to complete a particular quantum processing task.

Systems for performing quantum processing of one or more particles are well known in the art. Such systems comprise a plurality of quantum processing task components for performing one or more quantum processing tasks on at least one particle.

In the context of a quantum computing system, a qubit, or quantum bit, is the fundamental unit of quantum information, analogous to a classical bit. The system is configured to implement qubits using respective particles (e.g., as electrons, ions, or photons). More specifically, the quantum properties of these particles, such as spin, energy levels, or polarization, can be manipulated and measured to represent and process quantum information, i.e., represent qubits.

In the context of the present disclosure, a quantum processing task is any task, operation or action performed in carrying out a quantum processing procedure for interacting with at least one particle.

A quantum processing task may therefore effectively represent a fundamental building block for performing a quantum processing procedure. For instance, a quantum processing task may comprise modifying a property of light to be applied to at least one particle (e.g., which light is designed for cooling, reading, modifying and so on). As another example, a quantum processing task may comprise moving or shuttling a position of a particle within the system. As another example, a quantum processing task may comprise modifying a property of the at least one particle (e.g., to modify a qubit represented by the particle).

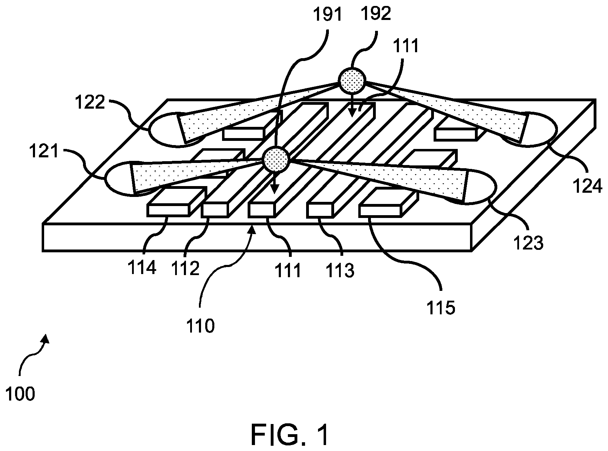

Fig. 1 conceptually illustrates a portion 100 of a system for performing quantum processing of one or more particles, for improved contextual understanding. In particular, the illustrated portion comprises a number of example quantum processing task components for performing respective quantum processing tasks on the one or more particles.

The system here comprises at least one electronics component 110 configured to perform a quantum processing task of controlling a property of an electric, magnetic and/or electromagnetic field for trapping and/or manipulating the position of at least one particle.

In particular, the at least one electronics component is here embodied as a particle trapping arrangement 110 configured to selectively trap a respective particle 191, 192 in each of a plurality of different trap locations or zones. Each particle may, for instance, be a charged particle such as an ion. The structure and configuration of suitable particle trapping arrangements are well known in the art.

Where the particle trapping arrangement is configured to trap atoms, it is known as an atom trapping arrangement.

One suitable example of a particle trapping arrangement 110 that employs electric and/or magnetic fields to trap a charged particle (e.g., an ion) is illustrated. Here, the illustrated particle trapping arrangement 110 comprises a central DC electrode. Each particle trap location may lie in the vicinity (e.g., above) the central DC electrode. Each central DC electrode 111 may be arranged between two RF electrodes 112, 113, wherein (in use) a voltage applied to the RF electrodes is controlled to maintain the position of the particle within the particle trap location. The particle trapping arrangement 110 may comprise further DC electrodes 114, 115 at either side of the array of the central DC electrode(s) 111 and the RF electrodes 112, 113. In use, the voltage of the further DC electrodes 114, 115 and/or the RF electrodes 112, 113 may be manipulated to control a movement of the trapped particle, e.g., between different particle trap locations or zones.

Other particle trapping arrangements are known in the art and can also be employed without departing from the scope of the present disclosure.

In this way, the particle trapping arrangement 110 is able to function as a particle shutting component configured to perform a quantum processing task of shuttling at least one particle to a desired location (e.g., a desired particle trap location).

Thus, one example of a quantum task processing component for use in the present disclosure is a particle shuttling component that is configured to perform a quantum processing task of shuttling at least one particle to a desired location (e.g., a desired particle trap location). This is achieved through application of voltages to different ones of the (e.g., DC and/or RF) electrodes.

The DC electrodes may be connected or connectable to one or more DC voltage sources (not visible in Fig. 1). Similarly, the RF electrodes may be connected or connectable to one or more RF voltage sources. The ground electrodes may be connected to a ground potential or earth. The electric wiring for the electrodes is not illustrated in the exemplary portion 100 of a system for performing quantum processing of Fig. 1.

The illustrated particle trapping arrangement makes use of electrodes to trap particles. However, other forms of particle trapping arrangements are known in the art, such as those that employ an optical lattice trapping technique, optical tweezer trapping technique, a magnetic trap technique, a magneto-optical trap technique and so on. These examples of particle trapping arrangement may also function as a particle shuttling component.

As another example, the system comprises at least one active photonics component configured to perform a quantum processing task of controlling a property of light for application to the at least one particle.

In particular, for the system illustrated in Fig. 1, the device further comprises at least one waveguide 121, 122, 123, 124 configured to guide light for application to a respective particle trap location.

In this way, one or more active photonics components may be coupled to the at least one waveguide and control one or more properties of light (such as laser light) provided to each waveguide, and therefore designed for application to the at least one particle to perform a particular quantum processing task.

Amongst other examples, the application of light to a particle trap location may, for instance, be used to perform a quantum processing task of: changing or reading a state of the particle (e.g., performing a qubit rotation task), cooling of the particle, performing one or more gating operations, and/or aiding in the trapping of a particle at the particle trap location. A wide variety of reasons, techniques and suitable photonic components for performing the application of light to a particle trapping location are known in the art. As another example, that is not shown in the portion 100 of the system illustrated by Fig. 1, light could be emitted to a particle trap location from a light source via an aperture or a mirror.

In the illustrated example, a pair of waveguides are illustrated for each particle trap location or zone. However, any number of waveguides may be provided for each particle trap location or zone, e.g., a single waveguide or a number equal to or more than three, four, five, six ... to ten waveguides per particle trap location. In examples, the light guide(s) could be situated above, below and/or to the side the particle trap location.

Of course, in some examples, the particle trapping arrangement of the device may be configured to define one or more particle trap locations to which no waveguide is able to guide light for application thereto.

Although not illustrated, it will be appreciated that at least some of the waveguides may be configured or designed to interact with one another, e.g., to provide a beam splitting functionality. The design and structure of such arrangements are well known in the art.

It will be appreciated that Fig. 1 is only schematic, and only illustrates a subset of the possible quantum processing task components of the device. Accordingly, in practice, the device 100 may comprise additional quantum processing task component. For instance, the device may comprise one or more particle trapping arrangements, additional particle trap locations and/or additional waveguides.

The device may comprise one or more other quantum processing task components, in addition to and/or instead of the above described quantum processing task components.

For instance, another example quantum processing task component is a qubit rotation component (single qubit-gate) configured to perform a qubit rotation task on a particle. A qubit rotation task functions to change to quantum state of the particle, thereby "rotating" the qubit represented by the particle. A qubit rotation component may be configured to, when appropriately controlled, apply electromagnetic fields or laser pulses to manipulate the quantum state of a particle representing a qubit. The rotation may be performed around different axes in the Bloch sphere representation of the qubit state.

Another example of a quantum processing task component is a multi-qubit gate component that may be configured to perform entangling operations between two or more qubits represented by particles, such as CNOT (controlled-NOT) or SWAP gates.

Another example of a quantum processing task component is a measurement component designed to perform quantum state readout of a particle, usable for obtaining or extracting results from quantum computations. The technique employed by the measurement component may be dependent upon the type of particle employed by the system. For instance, the measurement component may use a fluorescence detection technique for measuring trapped ions or charge sensing for measuring superconducting qubits.

Other suitable examples of quantum processing task components (and corresponding quantum processing tasks) would be readily apparent to the skilled person. In particular, other example quantum task components may comprise other forms of gates that are configured to perform a quantum gating task.

It will also be appreciated that a quantum processing task component may be capable of performing more than one quantum processing task. For instance, a light source may be able to perform at least the quantum processing tasks of: applying light to a particle or trap location; changing a color of light applied to a particle or trap location; changing an intensity of light applied to a particle or trap location and so on.

It will also be appreciated that a quantum processing task refers to any operation or action performed on a particle, a task performed in preparation for application to a particle and/or to treat a location after a particle has left, e.g., as part of a quantum processing procedure.

These tasks form the fundamental building blocks for more complex quantum operations and can include a wide range of activities. For example, a quantum processing task may involve preparing cooling light for application to a particle, which is crucial for maintaining the particle's quantum state. Other tasks might include modifying the properties of light to be applied to a particle, such as adjusting its intensity or wavelength, or controlling electromagnetic fields to manipulate the particle's position. Additionally, quantum processing tasks can encompass operations performed on a trap location after a particle has been moved, such as resetting the trap's electromagnetic field configuration or preparing it for the next particle. These tasks are typically executed by specialized quantum processing task components, each designed to perform specific operations within the quantum system.

Each quantum processing task component may be configured to perform its task(s) responsive to a control by a control system.

Thus, the system may comprise a control system for controlling an operation of each quantum processing task component. In particular, the control system may be configured to change or otherwise define the operation of each quantum processing task component (e.g., control the initiation of a quantum processing task performed by the quantum processing task component).

It has been recognized that quantum processing tasks form the basic building blocks for performing complex quantum processing procedures or calculations. At present, a designer of a quantum processing procedure therefore needs to carefully co-ordinate the performance of the individual quantum processing tasks to avoid or reduce a risk of conflict or interference between different quantum processing tasks. This coordination may become increasingly complex as the number of quantum processing tasks and components increases.

The present disclosure proposes a control mechanism for the control system that aims to simplify the coordination of the quantum processing tasks. In particular, the control mechanism utilizes a predefined clocking period to synchronize the operation of quantum processing task components, i.e., the performance of quantum processing tasks. More specifically, it is herein proposed to use a predefined clocking period that no less than a period of time taken by a predetermined one of the quantum processing task components to complete its respective quantum processing task.

In this context, a quantum processing task is a processing task for a (quantum) particle for the purposes of performing quantum computing. Thus, a quantum processing task refers to any operation or action performed on a particle, a task performed in preparation for application to a particle and/or to treat a location after a particle has left, e.g., as part of a quantum processing procedure.

By introducing such a predefined clocking period, the control system is able to synchronize the operations of the quantum processing task components in a structured manner. In particular, this provides scalability to the system, appreciating that, as quantum systems grow in complexity, a carefully coordinated synchronization approach is able to help manage an increasing number of quantum processing task components.

In other words, the proposed approach introduces the concept of a virtual clocking system for the control system, in which the virtual clocking system effectively defines a clocking signal that iteratively produces a beat every clocking period. The control system may be configured to change the operation of each quantum processing task component only when the clocking signal indicates a beat, i.e., synchronously with a beat or immediately responsive to the indicated beat.

In this way, the (virtual) clock signal serves as a mechanism for synchronizing the initiation of different quantum processing tasks that are to be executed at the same time.

For the avoidance of doubt, it is noted that the control system may separately comprise a clocking element, e.g., comprising a quartz-based and/or GPS-based clocking element, for producing a time reference signal. This clocking element (i.e., the time reference signal) may be used to generate the virtual clocking system's beats at the predefined clocking period intervals. In particular, the virtual clock will produce a clocking signal that is slower than the time reference signal produced by the clocking element.

The period of the time reference signal may, for instance, be significantly smaller (e.g., more than 10x smaller) than the duration of the clocking period. For instance, the period of the time reference signal may be more than 30 times or 100 times smaller than the duration of the clocking period. Thus, the frequency of the time reference signal may be substantially greater (e.g., no less than 10x greater, e.g., no less than 30x greater, e.g., no less than 100x greater) the frequency of the clocking signal produced by the virtual clock.

Purely by way of example, the high-precision time reference signal may have a frequency no less than 100 MHz (i.e., and a period of 10ns), with the clocking signal (produced by the virtual clock) having a frequency no more than 1 MHz, (i.e., a clocking period of less than 1 µs).

Thus, the present invention relies upon the recognition that given reusable quantum processing task components with reproducible quantum processes tasks, it is possible to synchronize the performance of tasks by introducing a common clock with a clocking period (i.e., unit time). Each quantum processing task takes at least one clocking period but may take up an integer multiple of the clocking period.

For example, changing the state of a light source (e.g., switching on/off) might require a single clocking period, while regulating the intensity of light output by the light source (e.g., to achieve a desired non-zero intensity) might require four clocking periods.

As another example, performing a single qubit operation (i.e., processing a single qubit using a quantum logic gate) on an ion may take a single clocking period, whereas performing an entangling operation on an ion may take ten clocking periods.

The actions of all quantum processing task components are performed in parallel at the same time. Each component has an internal state and actions yield a change of the state.

It should be noted that the performance of a single quantum processing task may, in practice, require the performance of multiple individual steps or sub-tasks. For instance, changing the state of a light source may comprise ramping a control signal for the light source up using a Blackman window function, which may require multiple individual sub-tasks or steps.

The time reference signal mentioned above may, for instance, be used to control the performance of one or more sub-tasks or steps required to execute or perform a quantum processing task.

A common clock and standardized actions of components allows for a reduction in the communication to the quantum processing task components. For example, if a component has 8 distinct possible tasks, only 3 bits of information per clocking period are required for this component in the simplest scheme.

Another advantage of the proposed system is that quantum algorithm designers are able to work with a more abstracted view of time, thinking in terms of clock cycles rather than precise microsecond timings. This increases an ease of producing and designing quantum processing procedures.

The proposed system is analogous to a finite state machine, in which the state of each component can only be changed to a non-idle state at fixed clocking periods (i.e., only at the point that the clocking signal produces a beat).

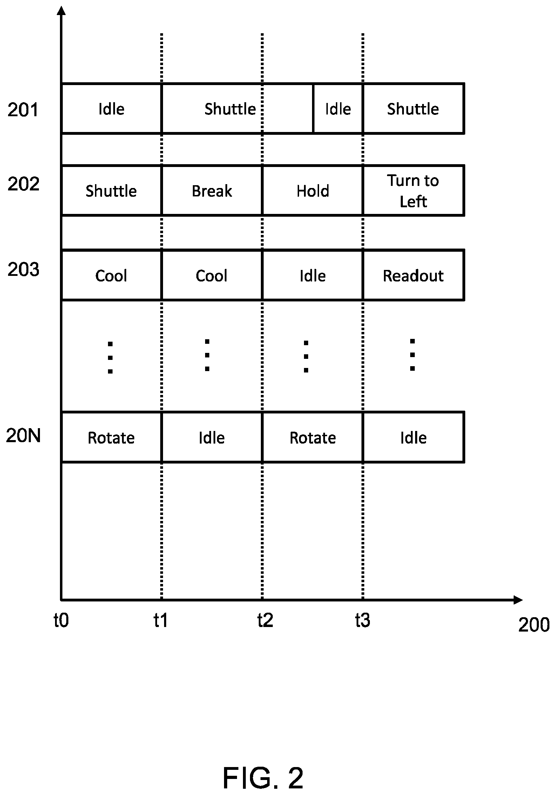

Fig. 2 schematically represents example states for a plurality of different quantum processing task components 201, 202, 203, ..., 20N, which are controlled according to the proposed system.

In particular, when controlled using the proposed approach each quantum processing task component is only able to change to a non-idle state at the start of each clocking period of the (virtual) clocking signal, i.e., synchronously with a beat of the clocking signal.

Fig. 2 illustrates some example control states for different forms of quantum processing task components. For the purposes of illustration, a first quantum processing task component 201 and a second quantum processing task component 202 may each be a shuttling component for manipulating the position of a particle. A third quantum processing task component 203 may be a photonic component. An N-th quantum processing task component 20N may be a qubit rotation component.

As illustrated in Fig. 2, the effective control state of each component is only changed to a non-idle control state synchronously with the beat of the clocking signal (i.e., at the start t0, t1, t2 of each clocking period).

It will be appreciated that an effective control state may change to an idle state without synchronization with a beat. This may, for instance, represent when a quantum processing task (for a particular control state) has been completed by the corresponding quantum processing task component.

Put yet another way, the control system is configured to control tasks of the quantum processing task components to be synchronized in a sequence of timeslots. The start of each timeslot indicates a time at which any quantum processing task is able to be initiated.

For example, in some embodiments, at the start of a first timeslot, a first set of tasks are initiated by the quantum processing task component(s). At the start of a second subsequent timeslot, a second set of tasks are initiated by the quantum processing task component(s). The timeslots in a sequence of timeslots have the same duration, such that the timeslots are periodic.

Accordingly, even though some of the tasks may finish earlier than others within a particular timeslot, or may otherwise require less time than the duration of the timeslot, the tasks across the device are synchronized such that each quantum process task component performs only one task per timeslot, regardless of which task is being performed.

In some embodiments, some individual tasks may require more than one timeslot. For example, some individual tasks may be allocated two, three, four, five, or another integer number of timeslots for completion.

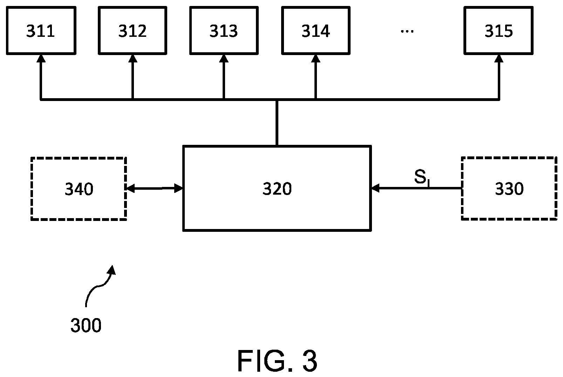

Fig. 3 schematically illustrates a proposed system 300 for performing quantum processing of one or more particles. The system 300 comprises a plurality of quantum processing task components 311, 312, 313, 314, ..., 31N and a control system 320, such as the control system previously disclosed.

Each quantum processing task component 311, 312, 313, 314, ..., 31N is configured to perform a respective quantum processing task for the one or more particles. Example quantum processing task components have been previously disclosed. Nonetheless, by way of further example and/or explanation, some example quantum processing tasks components are hereafter described.

In some examples, the plurality of quantum processing task components 311, 312, 313, 314, ..., 31N comprises at least one active photonics component configured to perform a quantum processing task of controlling a property of light for application to the at least one particle.

For instance, the at least one active photonics components may comprise a light control component configured to perform a quantum processing task of controlling whether or not light is applied to the at least one particle.

In some examples, the plurality of quantum processing task components 311, 312, 313, 314, ..., 31N comprises at least one electronics component configured to perform a quantum processing task of controlling a property of an electric, magnetic and/or electromagnetic field for trapping and/or manipulating the position of at least one particle. For instance, the at least one electronics component may comprise a particle shutting component configured to perform a quantum processing task of shuttling at least one particle to a desired location.

The plurality of quantum processing task components comprises a qubit rotation component configured to perform, as a quantum processing task, a qubit rotation task on a particle.

Preferably, the plurality of quantum processing task components are formed in single package, i.e., on a single integrated circuit or chip. This integration may enhance the system's performance by reducing signal propagation delays and improving overall efficiency. The single package approach may also simplify manufacturing processes and reduce the overall footprint of the quantum processing system.

However, the skilled person will appreciate that this is not essential. For instance, different packages of quantum processing task components may be communicatively or optically connected to provide a distributed quantum system.

The control system may (also) be integrated into the same package as the quantum processing task components. This integration may further reduce latency in control signals and improve synchronization between the control system and the quantum processing task components.

The control system 320 is designed for controlling an operation of each quantum processing task component. This can be achieved over appropriate communication channels between the control system 320 and each quantum processing task component.

In particular, the control system is configured to change the operation of each quantum processing task component only at a non-zero integer multiple of a predefined clocking period. The predefined clocking period is no less than a period of time taken by a predetermined one of the quantum processing task components to complete its respective quantum processing task.

In some examples, the clocking period is equal to the time taken by the predetermined component. This represents the minimum possible clocking period.

In other examples, the clocking period is a predetermined multiple of the time taken by the predetermined component. The value of the predetermined multiple is greater than 1 (e.g., 1.1., 1.2). This allows for some buffer time between task completions and the next clock cycle, and/or to account for minor fluctuations in the time taken to perform a particular quantum processing task.

Preferably, the predefined clocking period is no less than a period of time taken to perform the fastest quantum processing task by any of the quantum processing task components, e.g., equal to the time taken to perform the fastest quantum processing task.

In some examples, the plurality of quantum processing task components comprises a quantum logic gate configured to perform, as a quantum processing task, a quantum operation on a particle and/or set of particles (i.e., qubits). In such examples, the predefined clocking period is preferably no less than (e.g., equal to) a period of time taken by the quantum logic gate to perform the quantum operation. This ensures that the clocking period represents a time taken to perform a quantum processing task, i.e., a quantum operation.

Preferably, the quantum logic gate is not an identity gate or a global phase gate. Thus, some action is performed on the particle or set of particles.

The plurality of quantum processing task components comprises a qubit rotation component configured to perform, as a quantum processing task, a qubit rotation task on a particle. The predefined clocking period is no less than a period of time taken by the qubit rotation component to complete the qubit rotation task.

A single qubit rotation component may be configured to perform a plurality of different qubit rotation tasks, which will naturally take a different amount of time depending on the amount of rotation. For instance, the qubit rotation component may be able to perform a π/4 rotation and a π/2 rotation, of which the π/4 rotation will be faster. In such examples, the predefined clocking period may be set to be no less (e.g., equal to) the time taken to perform the fastest qubit rotation task (in this example, the π/4 rotation).

Thus, the qubit rotation component functions as the predetermined one of the quantum processing task components. The expected time taken by such a qubit rotation to complete the qubit rotation task may be known in advance, e.g., due to the underlying physical properties of the qubit rotation component and function.

Preferably, the predefined clocking period is no less than 10 times longer than a period of a time reference signal produced by a clocking element, e.g., comprising a quartz-based and/or GPS-based clocking element. Even more preferably, the predetermined clocking period is no less than 30 times longer than the period of the time reference signal or no less than 100 times longer than the period of the time reference signal. This approach helps increase the likelihood that even the shortest quantum processing tasks have sufficient time to complete within a single clocking period.

This approach effectively creates a hierarchical timing structure, where the time reference signal underlies a slower, more manageable clocking period for quantum task execution.

Preferably, the predefined clocking period is no less than 0.5µs, e.g. no less than 1 µs. This provides a reasonable estimate of the required length of time to perform an extremely fast quantum processing task with extant technology.

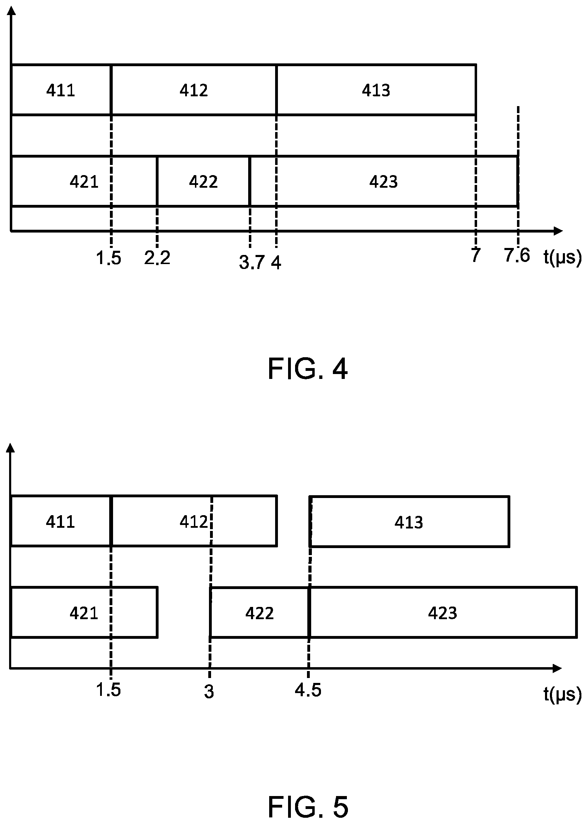

Figs. 4 and 5 illustrate the effect of the proposed approach.

In particular, Figs. 4 and 5 illustrates a first quantum processing procedure performed on a first particle and a simultaneous second quantum processing procedure performed on a second particle.

In the example illustrated by Fig. 4, the first and second quantum processing procedures are performed using an existing control approach. In the example illustrated by Fig. 5, the first and second quantum processing procedures are performed using the proposed control approach.

In this scenario, each quantum processing procedure comprises a sequence of quantum processing tasks (performed by appropriately controlled quantum processing task components).

The first sequence of quantum processing tasks comprises a first quantum processing task 411 (taking 1.5µs), a second quantum processing task 412 (taking 2.5µs) and a third quantum processing task 413 (taking 3µs). The second sequence of quantum processing tasks comprises a fourth quantum processing task 421 (taking 2.2 µs), a sixth quantum processing task 422 (taking 1.5µs) and a seventh quantum processing task 423 (taking 3.9µs).

In the existing control approach of Fig. 3, the control system is configured to control the quantum processing task components to perform the quantum processing task of each procedure immediately in succession. This requires careful control and timing of the tasks by the control system, significantly increasing a burden on the designer of the quantum processing procedure.

In particular, the existing control approach becomes increasingly problematic as the quantum processing system scales up in size (i.e., as the number of particles or qubits handled by a system increases). For a low number of qubits, it is relatively trivial to find an appropriate sequence of quantum processing tasks to perform a particular quantum processing procedure. However, as the number of qubits (and possible entanglements) increases, it will become ever more difficult to find an appropriate solution.

This also creates significant control complexity, e.g., as different quantum processing task components may initiate a task at different points in time. The initiation of tasks at different point in time can also cause timing issues, e.g., race conditions.

In the proposed control approach, the control system is configured to successively initiate each quantum processing task only at the start of a respective clocking period. Thus, the time between the initiation of different quantum processing tasks is an integer multiple of the clocking period. This reduces the difficulty of designing the quantum processing procedures, as each task is a fixed multiple of the clocking period.

The synchronization of the initiation of different quantum processing tasks also reduces a risk of timing issues, such as race conditions (where the outcome of a computation depends on the relative timing of events), occurring.

In quantum systems, where the state of qubits can be highly sensitive to timing, this synchronized initiation may also reduce a risk of errors or unexpected quantum states. For example, if two quantum gates are meant to operate sequentially on a qubit, any overlap in their execution times could lead to unexpected quantum states or errors in the computation. This is advantageously avoided using the proposed approach.

Thus, the clocking period conceptually represents the length of a timeslot. Each task may be allocated an integer number of timeslots (i.e., clocking periods) in which it is executed. The boundaries of timeslots (or clocking periods) for performing tasks are aligned with one another.

In particular, this approach reduces control complexity, as there are set time points at which any quantum processing task can be initiated, reducing control complexity across the network. This effect is enhanced when there are a large number of quantum processing procedures to be performed simultaneously, as is expected with increased scaling of the quantum systems. For example, the control (such as initialization and/or change) of states only at the beginning of the clocking period can be thought of as a heart beat that orchestrates globally the control of the quantum processing tasks periodically (and not individually for each quantum processing task during the clocking period).

The proposed approach thereby provides improved scalability of the proposed system(s).

In particular, the proposed approach effectively breaks complex tasks into simpler tasks makes it easier to manage larger systems (with more qubits). For instance, the same components can be used multiple times within the trap.

In the example illustrated in Figure 5, the clocking period is set to be equal to the length of time (i.e., duration) taken to perform the first quantum processing task 411 (e.g., 1.5 µs). However, variants will be apparent to the skilled person.

Turning back to Fig. 3, in some examples, the control system 320 is configured to receive an indication S_{I} of a desired quantum processing procedure; and control the plurality of quantum processing task components to perform a sequence of sets of one or more quantum processing tasks to execute the desired quantum processing procedure. A time between an initiation of each set of one or more quantum processing tasks is a non-zero integer multiple of the predefined clocking period.

In this way, the control system is able to translate the high-level instruction into a sequence of specific quantum processing tasks that need to be executed by the various components. This sequence is not executed continuously, but rather in discrete sets of tasks, with each set initiated at specific time intervals. These intervals are synchronized with the predefined clocking period, ensuring that the initiation of each set occurs at a time point that is a non-zero integer multiple of this period. For example, if the clocking period is 1.5 µs, task sets might be initiated at 1.5 µs, 3 µs, 4.5 µs, and so on.

By aligning task initiations with the clocking period, it ensures that all components in the system are operating in a synchronized manner, reducing the risk of timing conflicts or race conditions. Moreover, as quantum systems grow more complex with more components, this structured timing approach helps manage the increased complexity of coordinating multiple simultaneous operations.

The indication S_{I} may be carried by a digital control signal. Thus, the control system 320 may comprise a digital input interface for receiving a digital control signal carrying the indication S_{I}. The control signal may comprise a digital processor, examples of which are later provided, for processing the digital control signal and generating a respective control signal for each quantum processing component. In some examples, the control signal for each quantum processing component is an analog signal for direct control of the operation of the quantum processing component. As such, the control system 320 may comprise one or more digital-to-analog converters for generating the analog signal for each quantum processing component.

In some examples, the indication S_{I} of the desired quantum processing procedure is user-defined, e.g., generated at a user interface 330 of the system 300. By providing a user-defined indication, the system offers flexibility for individuals to design and execute custom quantum processing procedures tailored to their specific needs or experiments.

The user interface 330 may present a high-level abstraction of the available quantum processing tasks, allowing individuals or systems to construct procedures without needing to understand or specify the low-level details of each quantum processing task component. For example, it might offer a drag-and-drop interface for assembling quantum circuits, or a programming environment with quantum-specific commands and functions.

Once a user defines a desired quantum processing procedure through the interface 330, the system generates an indication S_{I} of this procedure. This indication S_{I} serves as an input to the control system 320, which then interprets it and translates it into the appropriate sequence of quantum processing tasks to be executed by the various quantum processing task components 211, 212, 213, 214, ..., 21N.

In some examples, the system 300 further comprising a storage system 340 configured to store, for each of a plurality of different quantum processing procedures, sequence data identifying a respective sequence of sets of one or more quantum processing tasks to be performed to execute the desired quantum processing procedure.

The sequence data stored by the storage system thereby effectively functions as a library for performing predefined quantum processing procedures, increasing an ease of performing the relevant procedures.

The control system 320 may be configured to, responsive to the indication of the desired quantum processing procedure, access the storage system to identify the sequence data corresponding to the desired quantum processing procedure; and control the plurality of quantum processing task components using the sequence data corresponding to the desired quantum processing procedure.

This approach also provides consistent performance of the quantum processing procedures.

Proposed approaches make use of a control system to control the operation of quantum task processing components.

The control system may comprise at least one processor and at least one memory carrying instructions that, when executed, cause the at least one processor to perform at least some of the desired functionality of the control system.

Each processor may be embodied as, for instance, one or more pieces of general-purpose and/or fixed function circuitry, such as a general-purpose microprocessor (e.g., a CPU), a field-programmable gate array (FPGA), an appropriately configured application-specific integrated circuit (ASIC), and/or a distributed processing arrangement (e.g., comprising multiple interconnected processing units working in parallel).

In the present disclosure, ordinal numbers (e.g. "first", "second" and so on) have been used purely to distinguish different elements from one another for the sake of clarity, and reference to a non-"first" (e.g. "second" or "third") element does not necessitate that a "first" element be present. The skilled person would be capable of relabeling any such elements as appropriate (e.g. relabeling a "second" element as a "first" element if only the second element is present).

## Claims

1. A system (300) for performing quantum processing of one or more particles (191, 192), the system comprising:
a plurality of quantum processing task components (201, 202, 203, ..., 20N; 311, 312, 313, 314, ..., 31N), wherein each quantum processing task component is configured to perform a respective quantum processing task (411, 412, 413; 421, 422, 423) for the one or more particles, and wherein the plurality of quantum processing task components comprises a qubit rotation component configured to perform, as a quantum processing task, a qubit rotation task on one or more particles (191, 192), and;
a control system (320) for controlling an operation of each quantum processing task component, wherein the control system is configured to change the operation of each quantum processing task component only at a non-zero integer multiple of a predefined clocking period; and
wherein the predefined clocking period is no less than a period of time taken by the qubit rotation component to complete the qubit rotation task.

2. The system (300) of claim 1, wherein the control system (320) is configured to:
define a clocking signal that iteratively produces a beat, wherein a time between each beat is equal to the predefined clocking period; and
change the operation of each quantum processing task component only when the clocking signal indicates a beat.

3. The system (300) of any one of claims 1 to 2, wherein the control system (320) is configured to change the operation of each quantum processing task component to synchrously initiate different quantum processing tasks that are to be executed at the same time.

4. The system (300) of claim 1 or 2, wherein the plurality of quantum processing task components (201, 202, 203, ..., 20N; 311, 312, 313, 314, ..., 31N) comprises at least one active photonics component configured to perform a quantum processing task of controlling a property of light for application to the at least one particle

5. The system (300) of claim 4, wherein the at least one active photonics components comprises: a light control component configured to perform a quantum processing task of controlling whether or not light is applied to the at least one particle;

6. The system (300) of any one of claims 1 to 3, wherein the plurality of quantum processing task components (201, 202, 203, ..., 20N; 311, 312, 313, 314, ..., 31N) comprises: at least one electronics component configured to perform a quantum processing task of controlling a property of an electric, magnetic and/or electromagnetic field for trapping and/or manipulating the position of at least one particle

7. The system (300) of any one of claims 1 to 3 or 6, wherein the plurality of quantum processing task components (201, 202, 203, ..., 20N; 311, 312, 313, 314, ..., 31N) comprises: a particle shuttling component configured to perform a quantum processing task of shuttling at least one particle to a desired location.

8. The system (300) of any one of claims 1 to 7, wherein the plurality of quantum processing task components are formed in single package.

9. The system (300) of claim 8, wherein the control system is formed in the single package.

10. The system (300) of any one of claims 1 to 9, wherein the control system (320) is configured to:
receive an indication of a desired quantum processing procedure; and
control the plurality of quantum processing task components (201, 202, 203, ..., 20N; 311, 312, 313, 314, ..., 31N) to a sequence of sets of one or more quantum processing tasks to execute the desired quantum processing procedure, wherein a time between an initiation of each set of one or more quantum processing tasks is a non-zero integer multiple of the predefined clocking period.

11. The system (300) of claim 10, wherein the indication of the desired quantum processing procedure is user-defined.

12. The system (300) of claim 10 or 11, further comprising a storage system (340) configured to store, for each of a plurality of different quantum processing procedures, sequence data identifying a respective sequence of sets of one or more quantum processing tasks to be performed to execute the desired quantum processing procedure,

13. The system (300) of claim 12, wherein the control system (320) is configured to:
responsive to the indication of the desired quantum processing procedure, access the storage system to identify the sequence data corresponding to the desired quantum processing procedure; and
control the plurality of quantum processing task components using the sequence data corresponding to the desired quantum processing procedure.

14. A particle trap device comprising the system of any one of claims 1 to 13, wherein the plurality of quantum processing task components (201, 202, 203, ..., 20N; 311, 312, 313, 314, ..., 31N) comprises a particle trapping arrangement comprising particle trap components configured to selectively trap a respective particle in each of a plurality of different particle trap locations.

15. The particle trap device of claim 14, further comprising for each particle trap location, at least one waveguide configured to guide light for application to said particle trap location.

## Patentansprüche

1. System (300) zum Durchführen von Quantenverarbeitung von einem oder mehreren Teilchen (191, 192), wobei das System umfasst:
eine Mehrzahl von Quantenverarbeitungs-Aufgabenkomponenten (201, 202, 203, ..., 20N; 311, 312, 313, 314, ..., 31N), wobei jede Quantenverarbeitungs-Aufgabenkomponente dazu ausgelegt ist, eine jeweilige Quantenverarbeitungs-Aufgabe (411, 412, 413; 421, 422, 423) für ein oder mehrere Teilchen durchzuführen, wobei die Mehrzahl von Quantenverarbeitungs-Aufgabenkomponenten eine Qubit-Rotationskomponente umfasst, die dazu ausgelegt ist, als Quantenverarbeitungs-Aufgabe eine Qubit-Rotationsaufgabe an einem oder mehreren Teilchen auszuführen (191, 192), und
ein Steuerungssystem (320) zum Steuern eines Betriebs jeder Quantenverarbeitungs-Aufgabenkomponente, wobei das Steuerungssystem dazu ausgelegt ist, den Betrieb jeder Quantenverarbeitungs-Aufgabenkomponente nur bei einem ganzzahligen Vielfachen einer vordefinierten Taktperiode ungleich null zu ändern; und
wobei die vordefinierte Taktperiode nicht kleiner als eine Periode ist, die die Qubit-Rotationskomponente benötigt, um die Qubit-Rotationsaufgabe abzuschließen.

2. System (300) nach Anspruch 1, wobei das Steuerungssystem (320) zu Folgendem ausgelegt ist:
Definieren eines Taktsignals, das iterativ einen Schlag erzeugt, wobei eine Zeit zwischen jedem Schlag gleich der vordefinierten Taktperiode ist; und
Ändern des Betriebs jeder Quantenverarbeitungs-Aufgabenkomponente nur dann, wenn das Taktsignal einen Schlag anzeigt.

3. System (300) nach einem der Ansprüche 1 bis 2, wobei das Steuerungssystem (320) dazu ausgelegt ist, den Betrieb jeder Quantenverarbeitungs-Aufgabenkomponente zu ändern, um synchron verschiedene Quantenverarbeitungs-Aufgaben zu initiieren, die zur gleiche Zeit ausgeführt werden sollen.

4. System (300) nach Anspruch 1 oder 2, **dadurch gekennzeichnet, dass** die Mehrzahl von Quantenverarbeitungs-Aufgabenkomponenten (201, 202, 203, ..., 20N; 311, 312, 313, 314, ..., 31N) mindestens eine aktive Photonikkomponente umfassen, die dazu ausgelegt ist, eine Quantenverarbeitungs-Aufgabe des Steuerns einer Eigenschaft von Licht zur Anwendung auf das mindestens eine Teilchen durchzuführen.

5. System (300) nach Anspruch 4, wobei die mindestens eine aktive Photonikkomponente umfasst: eine Lichtsteuerungskomponente, die dazu ausgelegt ist, eine Quantenverarbeitungs-Aufgabe des Steuerns, ob Licht auf das mindestens eine Teilchen angewendet wird oder nicht, durchzuführen;

6. System (300) nach einem der Ansprüche 1 bis 3, **dadurch gekennzeichnet, dass** die Mehrzahl von Quantenverarbeitungs-Aufgabenkomponenten (201, 202, 203, ..., 20N; 311, 312, 313, 314, ..., 31N) umfasst: mindestens eine Elektronikkomponente, die dazu ausgelegt ist, eine Quantenverarbeitungs-Aufgabe des Steuerns einer Eigenschaft eines elektrischen, magnetischen und/oder elektromagnetischen Feldes zum Einfangen und/oder Manipulieren der Position mindestens eines Teilchens auszuführen.

7. System (300) nach einem der Ansprüche 1 bis 3 oder 6, **dadurch gekennzeichnet, dass** die Mehrzahl von Quantenverarbeitungs-Aufgabenkomponenten (201, 202, 203, ..., 20N; 311, 312, 313, 314, ..., 31N) umfassen: eine Teilchen-Shuttle-Transport-Komponente, die dazu ausgelegt ist, eine Quantenverarbeitungs-Aufgabe des Shuttle-Transports von mindestens einem Teilchen an einen gewünschten Ort durchzuführen.

8. System (300) nach einem der Ansprüche 1 bis 7, wobei die Mehrzahl von Quantenverarbeitungs-Aufgabenkomponenten in einem einzelnen Gehäuse ausgebildet ist.

9. System (300) nach Anspruch 8, wobei das Steuerungssystem in dem einzelnen Gehäuse ausgebildet ist.

10. Vorrichtung (300) nach einem der Ansprüche 1 bis 9, wobei das Steuerungssystem (320) ferner zu Folgendem ausgelegt ist:
Empfangen einer Angabe des gewünschten Quantenverarbeitungs-Verfahrens; und
Steuern der Mehrzahl von Quantenverarbeitungs-Aufgabenkomponenten (201, 202, 203, ..., 20N; 311, 312, 313, 314, ..., 31N) zu einer Sequenz von Sätzen von einer oder mehreren Quantenverarbeitungs-Aufgaben, um die gewünschte Quantenverarbeitungs-Prozedur auszuführen, wobei eine Zeit zwischen einer Initiierung jedes Satzes von einer oder mehreren Quantenverarbeitungs-Aufgaben ein ganzzahliges Vielfaches der vordefinierten Taktperiode ist.

11. System (300) nach Anspruch 10, wobei die Angabe der gewünschten Quantenverarbeitungs-Prozedur anwenderdefiniert ist.

12. System (300) nach Anspruch 10 oder 11, das ferner ein Speichersystem (340) umfasst, das dazu ausgelegt ist, für jede von einer Mehrzahl von verschiedenen Quantenverarbeitungs-Prozeduren Sequenzdaten zu speichern, die eine jeweilige Sequenz von Sätzen von einer oder mehreren Quantenverarbeitungs-Aufgaben identifizieren, die zum Ausführen der gewünschten Quantenverarbeitungs-Prozedur durchzuführen sind.

13. System (300) nach Anspruch 12, wobei das Steuerungssystem (320) zu Folgendem ausgelegt ist:
als Antwort auf die Angabe der gewünschten Quantenverarbeitungs-Prozedur, Zugreifen auf das Speichersystem , um die Sequenzdaten zu identifizieren, die der gewünschten Quantenverarbeitungs-Prozedur entsprechen; und
Steuern der Mehrzahl von Quantenverarbeitungs-Aufgabenkomponenten unter Verwendung der Sequenzdaten, die der gewünschten Quantenverarbeitungs-Prozedur entsprechen.

14. Teilchenfangvorrichtung, die das System nach einem der Ansprüche 1 bis 13 umfasst, wobei die Mehrzahl von Quantenverarbeitungs-Aufgabenkomponenten (201, 202, 203, ..., 20N; 311, 312, 313, 314, ..., 31N) eine Teilchenfanganordnung umfasst, die Teilchenfangkomponenten umfasst, die dazu ausgelegt sind, selektiv ein jeweiliges Teilchen in jeder von einer Mehrzahl von verschiedenen Teilchenfangstellen einzufangen.

15. Teilchenfangvorrichtung nach Anspruch 14, die ferner für jede Teilchenfangstelle mindestens einen Wellenleiter umfasst, der dazu ausgelegt ist, Licht zur Anwendung auf die Teilchenfangstelle zu leiten.

## Revendications

1. Système (300) destiné à effectuer un traitement quantique sur une ou de plusieurs particules (191, 192), le système comprenant :
une pluralité de composants de tâche de traitement quantique (201, 202, 203, ..., 20N ; 311, 312, 313, 314, ..., 31N), chaque composant de tâche de traitement quantique étant conçu pour effectuer une tâche de traitement quantique respective (411, 412, 413 ; 421, 422, 423) pour la ou les particules, et la pluralité de composants de tâche de traitement quantique comprenant un composant de rotation de qubit conçu pour effectuer, en tant que tâche de traitement quantique, une tâche de rotation de qubit sur une ou plusieurs particules (191, 192) ; et
un système de contrôle (320) destiné à contrôler le fonctionnement de chaque composant de tâche de traitement quantique, le système de contrôle étant conçu pour modifier le fonctionnement de chaque composant de tâche de traitement quantique uniquement à un multiple entier non nul d'une période de cadencement prédéfinie ; et
dans lequel la période de cadencement prédéfinie n'est pas inférieure à un laps de temps pris par le composant de rotation de qubit pour achever la tâche de rotation de qubit.

2. Appareil (300) de la revendication 1, dans lequel le système de contrôle (320) est conçu pour :
définir un signal de cadencement qui produit de façon itérative un battement, un temps entre chaque battement étant égal à la période de cadencement prédéfinie ; et
modifier le fonctionnement de chaque composant de tâche de traitement quantique uniquement lorsque le signal de cadencement indique un battement.

3. Système (300) de l'une quelconque des revendications 1 à 2, dans lequel le système de contrôle (320) est conçu pour modifier le fonctionnement de chaque composant de tâche de traitement quantique afin de lancer de façon synchrone différentes tâches de traitement quantique qui doivent être exécutées en même temps.

4. Système (300) de la revendication 1 ou 2, dans lequel la pluralité de composants de tâche de traitement quantique (201, 202, 203, ..., 20N ; 311, 312, 313, 314, ..., 31N) comprend au moins un composant photonique actif conçu pour effectuer une tâche de traitement quantique consistant à contrôler une propriété de lumière destinée à être appliquée à l'au moins une particule.

5. Système (300) de la revendication 4, dans lequel l'au moins un composant photonique actif comprend : un composant de contrôle de la lumière conçu pour effectuer une tâche de traitement quantique consistant à contrôler si de la lumière est appliquée ou non à l'au moins une particule.

6. Système (300) de l'une quelconque des revendications 1 à 3, dans lequel la pluralité de composants de tâche de traitement quantique (201, 202, 203, ..., 20N ; 311, 312, 313, 314, ..., 31N) comprend : au moins un composant électronique conçu pour effectuer une tâche de traitement quantique consistant à contrôler une propriété d'un champ électrique, magnétique et/ou électromagnétique destiné à piéger et/ou manipuler la position d'au moins une particule.

7. Système (300) de l'une quelconque des revendications 1 à 3 ou 6, dans lequel la pluralité de composants de tâche de traitement quantique (201, 202, 203, ..., 20N ; 311, 312, 313, 314, ..., 31N) comprend : un composant de transport de particules conçu pour effectuer une tâche de traitement quantique consistant à transporter au moins une particule jusqu'à un emplacement souhaité.

8. Système (300) de l'une quelconque des revendications 1 à 7, dans lequel la pluralité de composants de tâche de traitement quantique est formée dans un unique boîtier.

9. Système (300) de la revendication 8, dans lequel le système de contrôle est formé dans l'unique boîtier.

10. Système (300) de l'une quelconque des revendications 1 à 9, dans lequel le système de contrôle (320) est conçu pour :
recevoir une indication d'une procédure de traitement quantique souhaitée ; et
imposer à la pluralité de composants de tâches de traitement quantique (201, 202, 203, ..., 20N ; 311, 312, 313, 314, ..., 31N) une séquence d'ensembles d'une ou plusieurs tâches de traitement quantique pour exécuter la procédure de traitement quantique souhaitée, un temps entre le lancement de chaque ensemble d'une ou plusieurs tâches de traitement quantique étant un multiple entier non nul de la période de cadencement prédéfinie.

11. Système (300) de la revendication 10, dans lequel l'indication de la procédure de traitement quantique souhaitée est définie par l'utilisateur.

12. Système (300) de la revendication 10 ou 11, comprenant en outre un système de stockage (340) conçu pour stocker, pour chaque procédure d'une pluralité de procédures de traitement quantique différentes, des données de séquence identifiant une séquence respective d'ensembles d'une ou plusieurs tâches de traitement quantique devant être effectuées pour exécuter la procédure de traitement quantique souhaitée.

13. Appareil (300) de la revendication 12, dans lequel le système de contrôle (320) est conçu pour :
en réponse à l'indication de la procédure de traitement quantique souhaitée, accéder au système de stockage pour identifier les données de séquence correspondant à la procédure de traitement quantique souhaitée ; et
contrôler la pluralité de composants de tâche de traitement quantique en utilisant les données de séquence correspondant à la procédure de traitement quantique souhaitée.

14. Dispositif piège à particules comprenant le système de l'une quelconque des revendications 1 à 13, la pluralité de composants de tâche de traitement quantique (201, 202, 203, ..., 20N ; 311, 312, 313, 314, ..., 31N) comprenant un agencement de piégeage de particules comprenant des composants de piège à particules conçus pour piéger sélectivement une particule respective à chaque emplacement d'une pluralité d'emplacements de piège à particules différents.

15. Dispositif piège à particules de la revendication 14, comprenant en outre, pour chaque emplacement de piège à particules, au moins un guide d'ondes conçu pour guider de la lumière destinée à être appliquée audit emplacement de piège à particules.
